# EUROPEAN PATENT APPLICATION

(11) **EP 4 451 318 A2**
(43) Date of publication of application: **23.10.2024**
(21) Application number: 24162335.4
(22) Date of filing: 08.03.2024
(51) Int. Cl.: H01L 21/822, H01L 21/8234, H01L 27/088, H01L 27/092, H01L 29/06, H01L 29/775

(54) **STACKED INTEGRATED CIRCUIT DEVICES INCLUDING STAGGERED GATE STRUCTURES AND METHODS OF FORMING THE SAME**

(30) Priority: 18.04.2023 US 202363496701 P; 27.09.2023 US 202318475322
(71) Applicant: Samsung Electronics Co., Ltd., Suwon-si, Gyeonggi-do 16677 (KR)
(72) Inventor: SONG, Seung Min, San Jose, CA 95134 (US); LEE, Jaehong, San Jose, CA 95134 (US); SEO, Kang-Ill, San Jose, CA 95134 (US)
(74) Representative: Kuhnen & Wacker Patent- und Rechtsanwaltsbüro PartG mbB

(57) **Abstract**

An integrated circuit device comprising: an upper transistor structure on a substrate, the upper transistor structure comprising a pair of upper source/drain regions spaced apart from each other in a first horizontal direction and an upper gate electrode between the pair of upper source/drain regions; a lower transistor structure between the substrate and the upper transistor structure, the lower transistor structure comprising a lower gate electrode; an upper insulating layer on the lower transistor structure, wherein the upper gate electrode is in the upper insulating layer; and a lower gate contact extending through the upper insulating layer and contacting the lower gate electrode, a center of the upper gate electrode in a second horizontal direction and a center of the lower gate electrode in the second horizontal direction are offset from each other in the second horizontal direction, and the second horizontal direction is perpendicular to the first horizontal direction.

## Description

### FIELD

The present disclosure generally relates to the field of electronics and, more particularly, to integrated circuits, including stacked transistors.

### BACKGROUND

Integrated circuit devices including stacked transistors such as a complementary field effect transistor (CFET) stack, were introduced to reduce their areas compared to those of corresponding non-stacked devices. However, the integrated circuit devices including stacked transistors may include various stacked elements which may make manufacturing process(es) complex and challenging.

### SUMMARY

According to some embodiments, an integrated circuit device comprising: an upper transistor structure on a substrate, the upper transistor structure comprising a pair of upper source/drain regions spaced apart from each other in a first horizontal direction and an upper gate electrode between the pair of upper source/drain regions; a lower transistor structure between the substrate and the upper transistor structure, the lower transistor structure comprising a lower gate electrode; an upper insulating layer on the lower transistor structure, wherein the upper gate electrode is in the upper insulating layer; and a lower gate contact extending through the upper insulating layer and contacting the lower gate electrode, wherein a center of the upper gate electrode in a second horizontal direction and a center of the lower gate electrode in the second horizontal direction are offset from each other in the second horizontal direction, and the second horizontal direction is perpendicular to the first horizontal direction.

According to some embodiments, an integrated circuit device comprising: first and second upper transistor structures that are on a substrate and are spaced apart from each other in a horizontal direction, the first and second upper transistor structures comprising first and second upper gate electrodes, respectively; a lower transistor structure between the substrate and the first and second upper transistor structures, the lower transistor structure comprising a lower gate electrode that comprises a portion not overlapped by the first and second upper gate electrodes; an intergate insulator extending between the lower gate electrode and the first and second upper gate electrodes; and a lower gate contact between the first and second upper gate electrodes, the lower gate contact extending through the intergate insulator and is contact with the portion of the lower gate electrode.

According to some embodiments, a method of forming an integrated circuit device, the method comprising: forming a preliminary structure on a substrate, the preliminary structure comprising a preliminary upper structure and a preliminary lower structure between the substrate and the preliminary upper structure, the preliminary lower structure comprising a lower insulator and a preliminary lower gate electrode in the lower insulator, and the preliminary upper structure comprising a preliminary upper gate layer; forming a lower gate contact opening extending through the preliminary upper gate layer, thereby forming first and second preliminary upper gate electrodes, the lower gate contact opening exposing the preliminary lower gate electrode, and the first and second preliminary upper gate electrodes being spaced apart from each other in a horizontal direction; and removing the preliminary lower gate electrode through the lower gate contact opening, thereby forming a lower gate electrode opening in the lower insulator; forming a lower gate electrode in the lower gate electrode opening; and then forming a lower gate contact in the lower gate contact opening.

### BRIEF DESCRIPTION OF THE DRAWINGS

FIG. 1 is a plan view of a stacked integrated circuit device according to some embodiments.
FIG. 2A is a cross-sectional view taken along the line A-A' of FIG. 1 according to some embodiments.
FIG. 2B is a cross-sectional view taken along the line B-B' of FIG. 1 according to some embodiments.
FIG. 2C is a cross-sectional view taken along the line C-C' of FIG. 1 according to some embodiments.
FIG. 3 is a flow chart of methods of forming a stacked integrated circuit device according to some embodiments.
FIGS. 4 through 20 are cross-sectional views illustrating methods of manufacturing a stacked integrated circuit device according to some embodiments.

### DETAILED DESCRIPTION

An integrated circuit device may include transistors (e.g., a lower transistor and an upper transistor) stacked in a vertical direction, and those stacked transistors are beneficial for increasing the integration density of the integrated circuit device. Those stacked transistors may be formed by processes performed separately at different times, and several elements (e.g., channel regions or gate electrode) of the stacked transistors can be formed to have different dimensions (e.g., dimensions in a width direction and/or in a height direction) and/or to include different materials. When transistors are stacked in a vertical direction and are formed through separate processes, however, there may be various difficulties in forming conducive contacts that are electrically connected to elements of those stacked transistors. For example, it may be difficult to form a contact that is in contact with an element of the lower transistor and is electrically connected to an element of a back-end-of-line (BEOL) structure, as the upper transistor is disposed between the element of the lower transistor and the BEOL structure. Further, it may be difficult to form an element of the lower transistor well aligned with an element of the upper transistor.

According to some embodiments of the invention, a lower gate electrode and an upper gate electrode and/or a lower source/drain region and an upper source/drain region are arranged in a staggered manner. The integrated density of a stacked integrated circuit device, therefore, may increase while maintaining enough spaces and degrees of design flexibility for contacts (e.g., gate contacts) that are electrically connected to the upper transistor structure and/or the lower transistor structure (e.g., an upper gate electrode and/or a lower gate electrode).

According to some embodiments of the present invention, the stacked integrated circuit device may be included in, for example, a standard cell (e.g., an inverter, a 2-input NAND gate, a 3-input NAND gate, a 2-input NOR gate, a 3-input NOR gate, an And-Or inverter (AOI), an Or-And inverter (OAI), an XNOR gate, an XOR gate, a multiplexer (MUX), a latch, or a D flip-flop), a passive device (e.g., a resistor or a capacitor) or a memory cell (e.g., a SRAM cell).

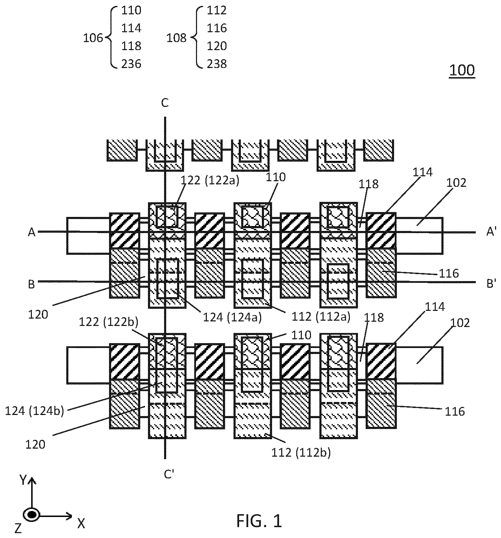

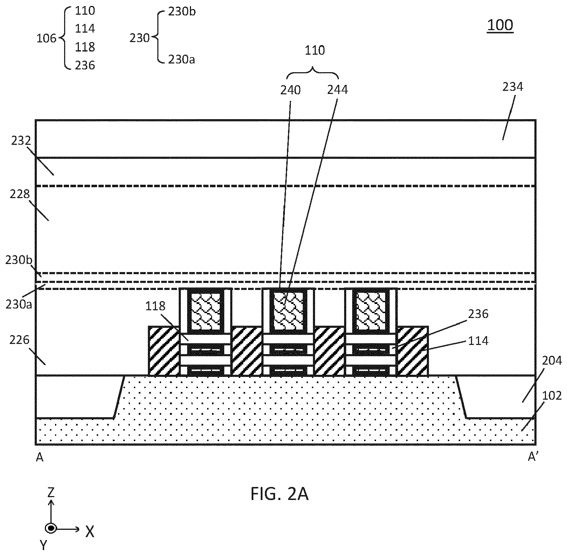

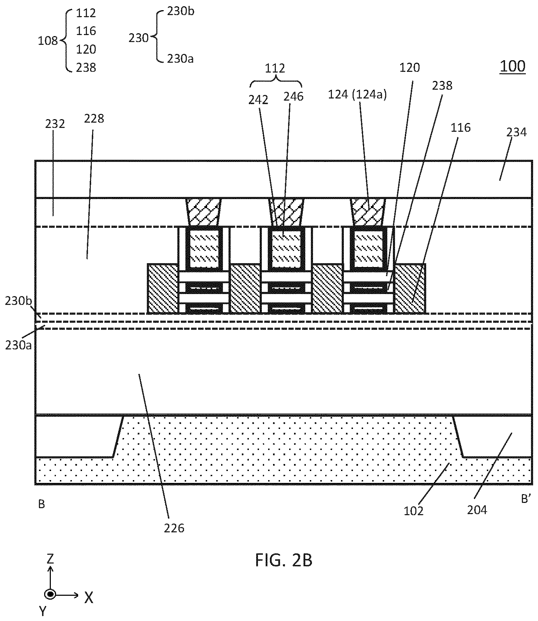

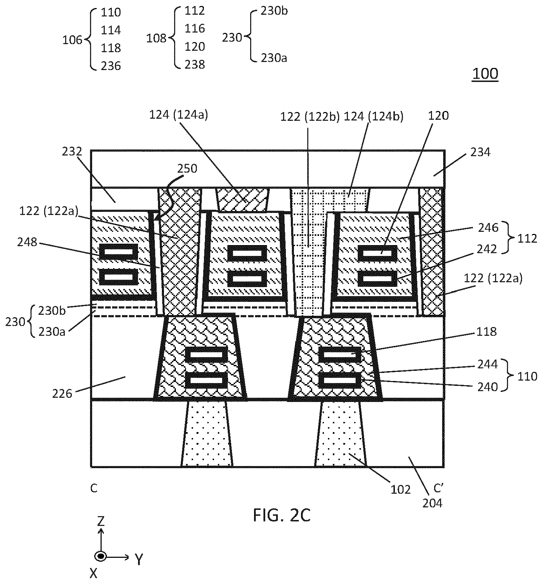

FIG. 1 is a plan view of a stacked integrated circuit device 100 according to some embodiments. FIG. 2A is a cross-sectional view taken along the line A-A' of FIG. 1 according to some embodiments. FIG. 2B is a cross-sectional view taken along the line B-B' of FIG. 1 according to some embodiments. FIG. 2C is a cross-sectional view taken along the line C-C' of FIG. 1 according to some embodiments.

Referring to FIGS. 1, 2A, 2B, and 2C, the stacked integrated circuit device 100 may include transistor stacks provided on a substrate 102. In some embodiments, each of the transistor stacks may include a lower transistor structure 106 on the substrate 102 and an upper transistor structure 108 stacked on the lower transistor structure 106. For example, the lower transistor structure 106 may be between the substrate 102 and the upper transistor structure 108. In some embodiments, the transistor stacks may be provided on a portion of the substrate 102 defined by a device isolation layer 204. An upper surface of the substrate 102 may be coplanar with an upper surface of the device isolation layer 204. The upper surface of the substrate 102 faces the transistor stacks, and the substrate 102 may further include a lower surface opposite the upper surface thereof.

The transistor stacks may be spaced apart from each other in a first direction X (also referred to as a first horizontal direction) and a second direction Y (also referred to as a second horizontal direction). The first direction X and the second direction Y may be parallel to the upper surface of the substrate 102 and/or the lower surface of the substrate 102. The first direction X and the second direction Y may intersect (e.g., perpendicularly intersect) each other.

The lower transistor structure 106 and the upper transistor structure 108 may have different conductivity types or the same conductivity type. In some embodiments, the lower transistor structure 106 may be a P-type transistor, and the upper transistor structure 108 may be a N-type transistor, or vice-versa. However, the present invention is not limited thereto.

The lower transistor structure 106 may include a lower gate electrode 110, a lower source/drain region 114 on and/or adjacent to a side surface of the lower gate electrode 110, a lower channel region 118 contacting the lower source/drain region 114 (e.g., a side surface of the lower source/drain region 114), and a lower gate spacer 236 (also referred to as a lower inner gate spacer) between the lower gate electrode 110 and the lower source/drain region 114. For example, the lower transistor structure 106 may include a pair of the lower source/drain regions 114 spaced apart from each other in the first direction X by the lower channel region 118, the lower gate electrode 110, and/or the lower gate spacer 236. The lower gate electrode 110 may include a lower metal gate layer 244 and a lower work function layer 240. Although not illustrated in FIGS. 2A, 2B, and 2C, a lower gate insulator may be formed to separate the lower channel regions 118 from the lower gate electrode 110. The lower gate insulator may be a single layer or may include multiple stacked layers. For example, the lower gate insulator may include a lower interfacial layer (e.g., a silicon oxide layer) contacting the lower channel regions 118 and a high-k insulating layer extending between the lower interfacial layer and the lower gate electrode 110. The high-k insulating layer may include, for example, Al₂O₃, HfO₂, ZrO₂, HfZrO₄, TiO₂, Sc₂O₃, Y₂O₃, La₂O₃, Lu₂O₃, Nb₂O₅, and/or Ta₂O₅.

In some embodiments, the lower transistor structure 106 may include multiple lower channel regions 118 that are stacked in a third direction Z (also referred to as a vertical direction) and are spaced apart from each other in the third direction Z. Although FIGS. 2A and 2C illustrate that each of the lower transistor structures 106 includes two lower channel regions 118, in some embodiments, the lower transistor structure 106 may include a single channel region 118 or two or more lower channel regions 118. The third direction Z may be perpendicular to the first direction X and/or the second direction Y. The third direction Z may be perpendicular to the upper surface of the substrate 102.

The upper transistor structure 108 may include an upper gate electrode 112, an upper source/drain region 116 on and/or adjacent to a side surface of the upper gate electrode 112, an upper channel region 120 contacting the upper source/drain region 116 (e.g., a side surface of the upper source/drain region 116), and an upper gate spacer 238 (also referred to as an upper inner gate spacer) between the upper gate electrode 112 and the upper source/drain region 116. For example, the upper transistor structure 108 may include a pair of the upper source/drain regions 116 spaced apart from each other in the first direction X by the upper channel region 120, the upper gate electrode 112, and/or the upper gate spacer 238. The upper gate electrode 112 may include an upper metal gate layer 246 and an upper work function layer 242. Although not illustrated in FIGS. 2A, 2B, and 2C, an upper gate insulator may be formed to separate the upper channel regions 120 from the upper gate electrode 112. The upper gate insulator may be a single layer or may include multiple stacked layers. For example, the upper gate insulator may include an upper interfacial layer (e.g., a silicon oxide layer) contacting the upper channel regions 120 and a high-k insulating layer extending between the upper interfacial layer and the upper gate electrode 112.

In some embodiments, the upper transistor structure 108 may include multiple upper channel regions 120 that are stacked in the third direction Z and are spaced apart from each other in the third direction Z. Although FIGS. 2B and 2C illustrate that each of the upper transistor structure 108 includes two upper channel regions 120, in some embodiments, the upper transistor structure 108 may include a single upper channel region 120 or two or more upper channel regions 120.

The upper channel region 120 and the lower channel region 118 may be spaced apart from each other in the third direction Z and may at least partially overlap with each other in the third direction Z. The upper gate electrode 112 and the lower gate electrode 110 may be spaced apart from each other in the third direction Z and may include respective portions that at least partially overlap with each other in the third direction Z. In some embodiments, the lower gate electrode 110 may have a shape the same as or similar to the upper gate electrode 112 in a plan view, but is not limited thereto. The upper source/drain region 116 and the lower source/drain region 114 may be spaced apart from each other in the third direction Z and may at least partially overlap with each other in the third direction Z. As used herein, "an element A overlapping an element B in a direction X" (or similar language) means that there is at least one line that extends in the direction X and intersects both the elements A and B.

In some embodiments, a center of the upper gate electrode 112 (e.g., the upper metal gate layer 246) in the second direction Y and a center of the lower gate electrode 110 (e.g., the lower metal gate layer 244) in the second direction Y may be offset from each other in the second direction Y. In some embodiments, the lower gate electrode 110 may have a first portion that does not overlap the upper gate electrode 112 in the third direction Z and a second portion that overlaps the upper gate electrode 112 in the third direction Z. In some embodiments, the upper gate electrode 112 may have a first portion that does not overlap the lower gate electrode 110 in the third direction Z and a second portion that overlaps the lower gate electrode 110 in the third direction Z. For example, the lower gate electrode 110 and the upper gate electrode 112 may be staggered in the third direction Z to have portions that are overlapped with each other in the third direction Z.

In some embodiments, a center of the upper channel region 120 in the second direction Y and a center of the lower channel region 118 in the second direction Y may be offset from each other in the second direction Y, as illustrated in FIG. 2C.

In some embodiments, each of the lower transistor structure 106 and the upper transistor structure 108 may have a structure different from that illustrated in FIGS. 1, 2A, 2B, and 2C. For example, each of the lower transistor structure 106 and the upper transistor structure 108 may be a gate-all-around (GAA) transistor including a single channel region or a fin-shaped field-effect transistor (FinFET).

The lower transistor structure 106 may be disposed in a first insulating layer 226 (also referred to as a lower insulating layer) that is disposed on the substrate 102. A second insulating layer 228 (also referred to as an upper insulating layer) may be disposed on the first insulating layer 226. The upper transistor structure 108 may be disposed in the second insulating layer 228.

In some embodiments, a third insulating layer 232 and a fourth insulating layer 234 may be sequentially provided on the second insulating layer 228. However, the present invention is not limited to the numbers or relative locations of the insulating layers. For example, an upper surface of a first portion of the second insulating layer 228 may be coplanar with an upper surface of the third insulating layer 232, and an upper surface of a second portion of the second insulating layer 228 may be lower (e.g., closer to the upper surface of the substrate 102) than the upper surface of the third insulating layer 232. In some embodiments, the third insulating layer 232 and the fourth insulating layer 234 may comprise an integrated unitary structure. An integrated unitary structure herein may refer to a structure formed by the same process or the same series of processes without visible interface(s) between sub-elements therein or may include the same material such that there is no visible interface between sub-elements therein.

In some embodiments, an intergate insulator 230 may be disposed between the first insulating layer 226 and the second insulating layer 228. The intergate insulator 230 may include a first intergate insulator 230a disposed on the first insulating layer 226, and a second intergate insulator 230b disposed between the first intergate insulator 230a and the second insulating layer 228. In some embodiments, the intergate insulator 230 may be a single layer (e.g., a monolithic layer). Interfaces (represented by dotted lines in FIGS. 2A, 2B, and 2C) between the first insulating layer 226, the first intergate insulator 230a, the second intergate insulator 230b, the second insulating layer 228, the third insulating layer 232, and the fourth insulating layer 234 may not be visible.

Although not explicitly illustrated in FIGS. 1, 2A, 2B, and 2C, an upper structure may be provided in and/or on the third and fourth insulating layers 232 and 234. However, the present invention is not limited to the location of the upper structure within the insulating layers (e.g., the third and fourth insulating layers 232 and 234). The upper structure may include elements formed by the middle-end-of-line (MEOL) portion and/or the back-end-of-line (BEOL) portion of device fabrication. The upper structure may include and insulating elements (e.g., interlayer insulating layer(s), etch stop layer(s), barrier layer(s), adhesion layer(s) and/or spacer(s)) and conductive elements (e.g., wire(s) or via plug(s)).

The substrate 102 may include semiconductor material(s), for example, Si, Ge, SiGe, GaP, GaAs, SiC, SiGeC, and/or InP and/or may include insulating material(s), for example, silicon oxide, silicon oxynitride, silicon nitride, silicon carbonitride and/or a low-k material. In some embodiments, the substrate 102 may be a bulk substrate (e.g., a bulk silicon substrate), a semiconductor on insulator (SOI) substrate or an insulating layer (e.g., a monolithic insulating layer). For example, the substrate 102 may be a silicon wafer. The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

Each of the device isolation layer 204, the first, second, third, and fourth insulating layers 226, 228, 232, and 234, and the intergate insulator 230 may include insulating material(s) (e.g., silicon oxide, silicon oxynitride, silicon nitride, silicon carbonitride and/or a low-k material). In some embodiments, the intergate insulator 230 may include silicon oxynitride and the first, second, third, and fourth insulating layers 226, 228, 232, and 234 may include silicon nitride. Each of the device isolation layer 204, the first, second, third, and fourth insulating layers 226, 228, 232, and 234, and the intergate insulator 230 may be a single layer or multiple layers stacked on the substrate 102.

The lower gate electrode 110 and the upper gate electrode 112 may include the same material(s) or different material(s). The lower and upper metal gate layers 244 and 246 may include metallic layer(s) that include, for example, tungsten (W), aluminum (Al), copper (Cu), molybdenum (Mo) and/or ruthenium (Ru). The lower and upper work function layers 240 and 242 may include, for example, a TiN layer, a TaN layer, a TiAl layer, a TiC layer, a TiAlC layer, a TiAlN layer and/or a WN layer, respectively.

The work function layer(s) (e.g., the lower work function layer 240 or upper work function layer 242) may be respectively provided between the metallic layer(s) (e.g., the lower metal gate layer 244 or upper metal gate layer 246) and the channel region(s) (e.g., the lower channel region 118 or the upper channel region 120). For example, the lower work function layer 240 may extend between the lower metal gate layer 244 and the lower channel region 118, and the upper work function layer 242 may extend between the upper metal gate 246 and the upper channel region 120.

In some embodiments, the lower work function layer 240 may extend between the lower metal gate layer 244 and the intergate insulator 230 (e.g., the first intergate insulator 230a). The lower work function layer 240 may be in contact with the intergate insulator 230 (e.g., the first intergate insulator 230a). In some embodiments, the upper work function layer 242 may extend between the upper metal gate layer 246 and the intergate insulator 230 (e.g., the second intergate insulator 230b). The upper work function layer 242 may be in contact with the intergate insulator 230 (e.g., the second intergate insulator 230b).

Each of the lower channel region 118 and the upper channel region 120 may include semiconductor material(s) (e.g., Si, Ge, SiGe, GaP, GaAs, SiC, SiGeC and/or InP). In some embodiments, the lower channel region 118 and the upper channel region 120 may include the same material(s). In some embodiments, each of the lower channel region 118 and the upper channel region 120 may be a nanosheet that may have a thickness in a range of from 1 nm to 100 nm in the third direction Z or may be a nanowire that may have a circular cross-section with a diameter in a range of from 1 nm to 100 nm.

Each of the lower source/drain region 114 and the upper source/drain region 116 may include semiconductor layer(s) (e.g., a silicon layer and/or a silicon germanium layer) and may additionally include dopants in the semiconductor layer(s). In some embodiments, each of the lower source/drain region 114 and the upper source/drain region 116 may include metal layer(s) that include, for example, W, Al, Cu, Mo and/or Ru.

Each of the lower gate spacer 236 and the upper gate spacer 238 may include, for example, silicon oxide, silicon oxynitride, silicon nitride, silicon carbonitride and/or a low-k material. The lower gate spacer 236 and the upper gate spacer 238 may include the same material(s) or different material(s).

Referring to FIG. 2C, the stacked integrated circuit device 100 may further include a lower gate contact opening 250 on the lower gate electrode 110. The lower gate contact opening 250 may extend through the intergate insulator 230 and the second insulating layer 228 in the third direction Z. However, the present invention is not limited thereto. For example, the lower gate contact opening 250 may also extend through the third and fourth insulating layers 232 and 234 in the third direction Z. In some embodiments, a contact insulator 248 may be disposed in the lower gate contact opening 250. For example, the contact insulator 248 may conformally extend along an inner side surface of the lower gate contact opening 250.

Still referring to FIG. 2C, a lower gate contact 122 may be disposed in the lower gate contact opening 250. For example, the lower gate contact 122 may be between side surfaces of the contact insulator 248 in the lower gate contact opening 250. In some embodiments, the lower gate contact 122 may extend through the second insulating layer 228 and the intergate insulator 230 in the third direction Z to be electrically connected to (e.g., to contact) the lower gate electrode 110 (e.g., the lower metal gate layer 244). In some embodiments, the lower gate contact 122 may extend through the third insulating layer 232 in the third direction Z, and an upper surface of the lower gate contact 122 may be coplanar with an upper surface of the third insulating layer 232. However, the present invention is not limited thereto. For example, the lower gate contact 122 may also extend through the fourth insulating layer 234 to be electrically connected (e.g., to contact) to the upper structure. In some embodiment, a portion (e.g., an upper portion) of the lower gate contact 122 may be formed by the middle-end-of-line (MEOL) portion and/or the back-end-of-line (BEOL) portion.

Still referring to FIG. 2C, the lower gate contact 122 may contact a first portion of the lower gate electrode 110 (e.g., the lower metal gate layer 244) that is not overlapped with the upper gate electrode 112 in the third direction Z. For example, the lower gate contact 122 may contact the first portion of the lower gate electrode 110. The lower gate contact 122 may contact an upper surface of the lower gate electrode 110 or may extend into an upper portion of the lower gate electrode 110. A width of the lower gate contact 122 in the second direction Y and/or the first direction X may increase as a distance from the upper surface of the lower gate electrode 110 increases. However, the present invention is not limited thereto the shape of the lower gate contact 122. The lower gate contact 122 may comprise a single layer or multiple layers.

In some embodiments, a plurality of the lower gate contacts 122 may be respectively disposed on the lower gate electrodes 110. For example, the plurality of the lower gate contacts 122 may include a first lower gate contact 122a and a second lower gate contact 122b. Referring to FIG. 2C, the first lower gate contact 122a and the second lower gate contact 122b may be spaced apart from each other in the second direction Y. For example, the first lower gate contact 122a and the second lower gate contact 122b may be spaced apart from each other by the upper transistor structure 108 (e.g., the upper gate electrode 112) and the contact insulator 248. In some embodiments, the lower gate contact 122 may be disposed adjacent to the upper transistor structure 108 (e.g., the upper gate electrode 112) and/or between the upper transistor structures 108 (e.g., the upper gate electrodes 112). The lower gate contact 122 may be spaced apart from the upper transistor structure 108 (e.g., the upper gate electrode 112) by the contact insulator 248. For example, the first lower gate contact 122a may extend in the third direction Z adjacent to the upper transistor structure 108 (e.g., the upper gate electrode 112) and/or between the upper transistor structures 108 (e.g., the upper gate electrodes 112), and the second lower gate contact 122b may extend in the third direction Z between the upper transistor structures 108 (e.g., the upper gate electrodes 112).

In some embodiments, the stacked integrated circuit device 100 may further include an upper gate contact 124 on the upper transistor structure 108 (e.g., the upper gate electrode 112). The upper gate contact 124 may extend through the third insulating layer 232. For example, the upper gate contact 124 may also extend through the fourth insulating layer 234 to be electrically connected (e.g., to contact) to the upper structure. In some embodiment, a portion (e.g., an upper portion) of the upper gate contact 124 may be formed by the middle-end-of-line (MEOL) portion and/or a part of the back-end-of-line (BEOL) portion.

Still referring to FIG. 2C, a plurality of the upper gate contacts 124 may be on the upper gate electrodes 112. The plurality of the upper gate contacts 124 may contact the upper gate electrodes 112, respectively. The plurality of the upper gate contacts 124 may include, for example, a first upper gate contact 124a and a second upper gate contact 124b. The first upper gate contact 124a may be spaced apart from the lower gate contact 122 (e.g., the first lower gate contact 122a). The second upper gate contact 124b may be electrically connected (e.g., contact) the lower gate contact 122 (e.g., the second lower gate contact 122b). That is, the upper gate electrode 112 and the lower gate electrode 110 may be electrically connected to each other through the upper gate contact 124 (e.g., the second upper gate contact 124b) and the lower gate contact 122 (e.g., the second lower gate contact 122b). However, the present invention is not limited to the spatial relationship and electrical connections of the upper gate contacts 124 and lower gate contacts 122 described herein. The upper gate contact 124 (e.g., the second upper gate contact 124b) and the lower gate contact 122 (e.g., the second lower gate contact 122b), which contact each other, may have an integrated unitary structure.

In some embodiments, although not shown in FIGS. 2A, 2B, and 2C, an integrated circuit device 100 may further include a backside power distribution network structure (BSPDNS) provided on a lower surface of the substrate 102 and may also include contact(s) (also referred to as backside gate contact(s)) that correspond to the lower gate contact (e.g., the lower gate contact 122) and the upper gate contact (e.g., the upper gate contact 124), each of which electrically connect a respective one of the upper gate electrode 112 and the lower gate contact 122 to a conductive element of the BSPDN (e.g., conductive wire(s) or conductive via(s)). Those backside gate contacts may be provided in the substrate 102 and/or the device isolation layer 204 and may extend in the third direction Z. As illustrated in FIGS. 1, 2A, 2B, and 2C, the upper gate electrode 112 includes a portion not overlapping any conductive element (e.g., the lower gate electrode 110), which is provided between the upper gate electrode 112 and the substrate 102, in the third direction Z, and thus a backside gate contact, which is in contact with the upper gate electrode 112 and an element of the BSPDN, can have a straight line shape in a cross-section, rather than a curved shape or a shape with multiple bends.

Further, although not shown in FIGS. 1, 2A, 2B, and 2C, source/drain contacts, each of which contacts a respective one of the lower source/drain region 114 and the upper source/drain region 116 may be provided in the integrated circuit device 100. Similar to the gate contacts described previously, those source/drain contacts may include a first group of the source/drain contacts (also referred to as frontside source/drain contacts) that may be provided in the second insulating layer 228 and/or third insulating layer 232, and a second group of the source/drain contacts (also referred to as backside source/drain contacts) that may be provided in the substrate 102 and/or device isolation layer 204.

As a lower gate electrode and an upper gate electrode and/or a lower source/drain region and an upper source/drain region are disposed in a staggered manner, the integrated density of a stacked integrated circuit device may increase while maintaining enough spaces and degrees of design flexibility for contacts (e.g., an upper gate contact and/or a lower gate contact) that are electrically connected to the upper transistor structure and/or the lower transistor structure (e.g., the upper gate electrode and/or the lower gate electrode).

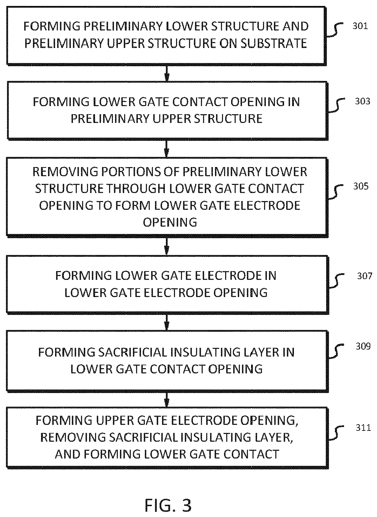

FIG. 3 is a flow chart of methods of forming a stacked integrated circuit device (e.g., the stacked integrated circuit device 100 referring to FIGS. 1, 2A, 2B, and 2C) according to some embodiments.

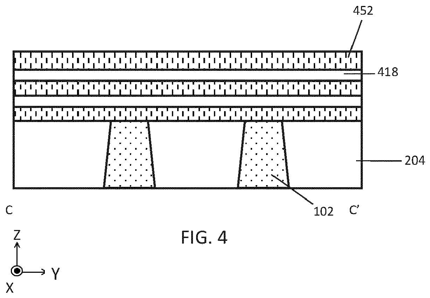

FIGS. 4 through 20 are cross-sectional views illustrating methods of manufacturing a stacked integrated circuit device (e.g., the stacked integrated circuit device 100 referring to FIGS. 1, 2A, 2B, and 2C) according to some embodiments. Referring to FIGS. 3 through 11, the methods of manufacturing a stacked integrated circuit device (e.g., the stacked integrated circuit device 100 referring to FIGS. 1, 2A, 2B, and 2C) may include providing the substrate 102, forming a preliminary lower structure 1060 on the substrate 102, and forming a preliminary upper structure 1162 on the preliminary lower structure 1060 (Block 301 in FIG. 3). In some embodiments, a preliminary intergate insulator 1130 may be formed between the preliminary upper structure 1162 and the preliminary lower structure 1060. The preliminary intergate insulator 1130 may be formed by, for example, a bonding process between the preliminary upper structure 1162 and the preliminary lower structure 1060, but is not limited thereto.

Referring to FIG. 4, preliminary lower channel layers 418 and lower sacrificial layers 452 may be formed on the substrate 102 and/or the device isolation layer 204. For example, the preliminary lower channel layers 418 may be alternately stacked with the lower sacrificial layers 452 in the third direction Z on the substrate 102 and/or the device isolation layer 204. Although FIG 4 illustrates two preliminary lower channel layers 418 and three lower sacrificial layers 452, the present invention is not limited to the numbers of the preliminary lower channel layers 418 or the lower sacrificial layers 452.

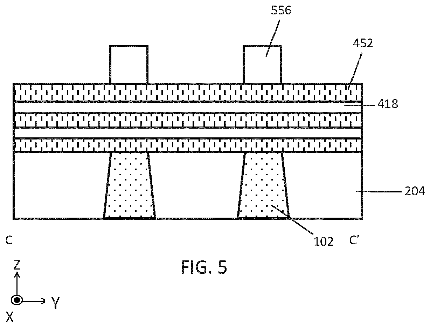

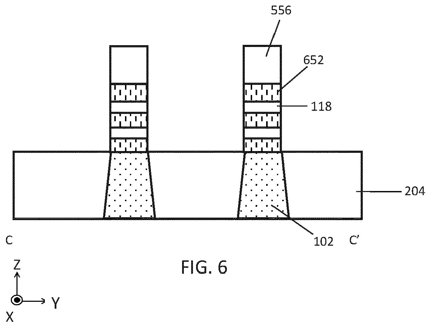

Referring to FIGS. 5 and 6, the preliminary lower channel layers 418 and the lower sacrificial layers 452 may be patterned (e.g., etched) using a lower mask layer 556 thereon to form the lower channel regions 118 and lower sacrificial patterns 652.

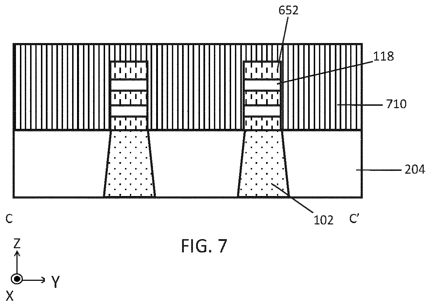

Referring to FIG. 7, a preliminary lower gate layer 710 may be formed on the substrate 102 and the device isolation layer 204. The preliminary lower gate layer 710 may be formed on the lower channel regions 118 and the lower sacrificial patterns 652. For example, the preliminary lower gate layer 710 may be formed on side surfaces of the lower channel regions 118 and the lower sacrificial patterns 652 and an upper surface of the lower sacrificial pattern 652.

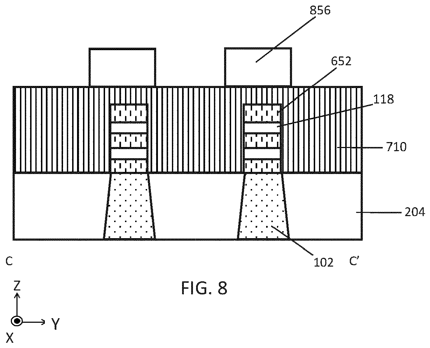

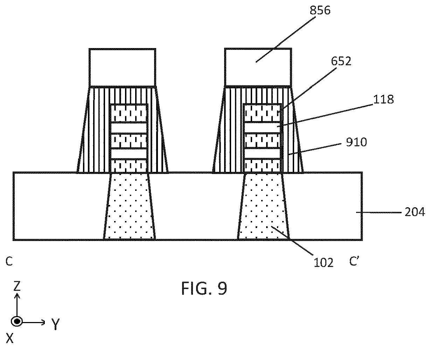

Referring to FIGS. 8 and 9, the preliminary lower gate layer 710 may be patterned (e.g., etched) by using a lower gate mask layer 856 to form a preliminary lower gate electrode 910. In some embodiments, a width of the preliminary lower gate electrode 910 in the second direction Y and/or the first direction X may decrease as a distance from the upper surface of the substrate 102 increases in the third direction Z. However, the present invention is not limited to the shape of the preliminary lower gate electrode 910.

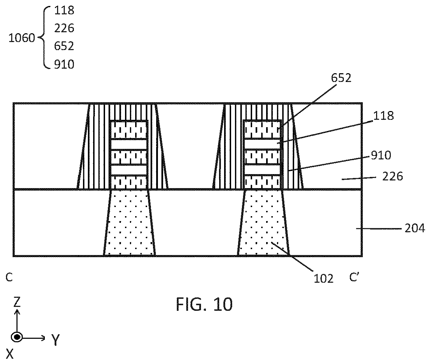

Referring to FIG. 10, the first insulating layer 226 may be formed on the preliminary lower gate electrode 910, the substrate 102 and the device isolation layer 204. In some embodiments, an upper surface of the first insulating layer 226 may be coplanar with an upper surface of the preliminary lower gate electrode 910. However, the present invention is not limited thereto the relative location of the upper surfaces of the preliminary lower gate electrode 910 and the first insulating layer 226.

The preliminary lower structure 1060 may include the first insulating layer 226, the preliminary lower gate electrode 910 in the first insulating layer 226, and the lower channel regions 118 and the lower sacrificial patterns 652 that are stacked in the third direction Z in the preliminary lower gate electrode 910. The lower channel regions 118 may be alternately stacked with the lower sacrificial patterns 652 in the third direction Z in the preliminary lower gate electrode 910.

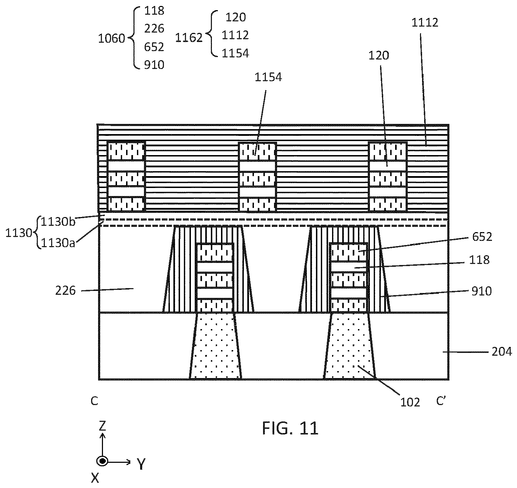

Referring to FIG. 11, the upper channel regions 120, upper sacrificial patterns 1154, and a preliminary upper gate layer 1112 may be formed on the preliminary lower structure 1060. The upper channel regions 120, the upper sacrificial patterns 1154, and the preliminary upper gate layer 1112 may be formed by similar processes described with reference to FIG. 4 through FIG. 7.

Still referring to FIG. 11, the preliminary upper structure 1162 may include the upper channel regions 120, the upper sacrificial patterns 1154, and the preliminary upper gate layer 1112. The upper channel regions 120 and the upper sacrificial patterns 1154 may be alternately stacked in the third direction Z. In some embodiments, a preliminary intergate insulator 1130 may be formed between the preliminary upper structure 1162 and the preliminary lower structure 1060. The preliminary intergate insulator 1130 may include a first preliminary intergate insulator 1130a and a second preliminary intergate insulator 1130b. The preliminary intergate insulator 1130 may be formed by, for example, a bonding process between the preliminary lower structure 1060 and the preliminary upper structure 1162. For example, the first preliminary intergate insulator 1130a may be disposed on the preliminary lower structure 1060 and may be placed to face a lower surface of the preliminary upper structure 1162. The second preliminary intergate insulator 1130b may be disposed below the preliminary upper structure 1162 facing an upper surface of the preliminary lower structure 1060. The preliminary intergate insulator 1130 may be formed by bonding a lower surface of the second preliminary intergate insulator 1130b and an upper surface of the first preliminary intergate insulator 1130a.

The preliminary upper gate layer 1112 and the preliminary lower gate electrode 910 may include, for example, poly-silicon. In some embodiments, the upper channel regions 120 may be formed in a staggered manner with the lower channel regions 118 in the third direction Z. For example, the center of the upper channel region 120 in the second direction Y and the center of the lower channel region 118 in the second direction Y may be offset from each other in the second direction Y.

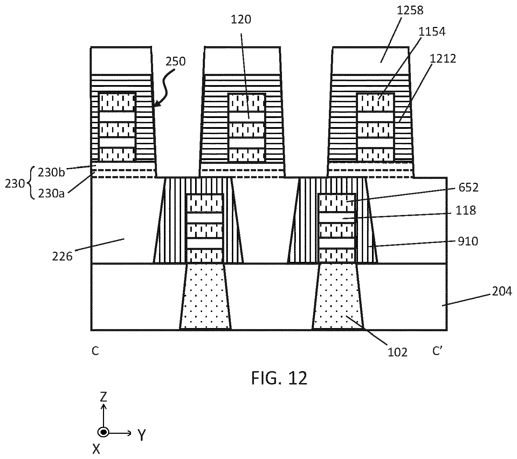

Referring to FIGS. 3 and 12, the methods of manufacturing a stacked integrated circuit device (e.g., the stacked integrated circuit device 100 referring to FIGS. 1, 2A, 2B, and 2C) may further include forming the lower gate contact opening 250 that extends through the preliminary upper gate layer 1112 (referring to FIG. 11), thereby forming a preliminary upper gate electrode 1212 (or the preliminary upper gate electrodes 1212) (Block 303 in FIG. 3). In some embodiments, the lower gate contact opening 250 may extend through the preliminary intergate insulator 1130 (e.g., the first and second preliminary intergate insulators 1130a and 1130b) to form the intergate insulator 230 (e.g., the first and second intergate insulators 230a and 230b). The lower gate contact opening 250 may expose at least a portion (e.g., a portion of an upper surface) of the preliminary lower gate electrode 910. The lower gate contact opening 250 may be formed by using an upper gate mask layer 1258 on the preliminary upper gate layer 1112 (referring to FIG. 11). The upper gate mask layer 1258 may include, for example, silicon nitride.

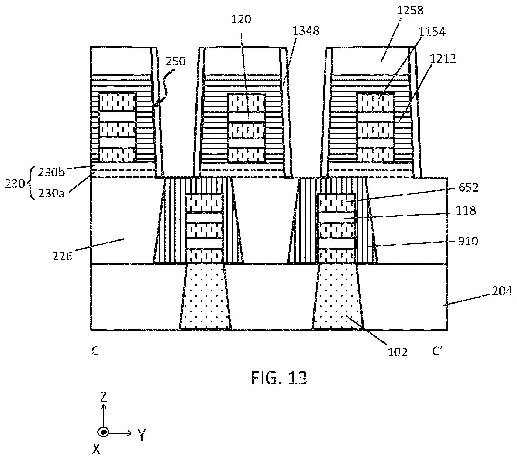

Referring to FIG. 13, a preliminary contact insulator 1348 may be formed in the lower gate contact opening 250. For example, the preliminary contact insulator 1348 may conformally extend along an inner side surface of the lower gate contact opening 250, and the preliminary contact insulator 1348 may have a uniform thickness along the inner side surface of the lower gate contact opening 250. In some embodiments, the preliminary contact insulator 1348 may conformally extend along side surfaces of the upper gate mask layer 1258, and the preliminary contact insulator 1348 may have a uniform thickness along the side surface of the upper gate mask layer. However, the present invention is not limited thereto.

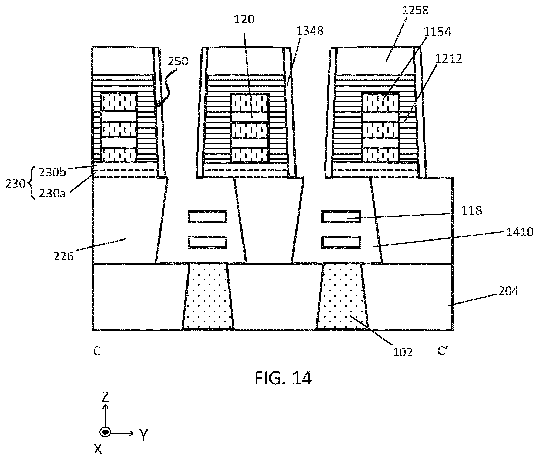

Referring to FIGS. 3 and 14, the preliminary lower gate electrode 910 and the lower sacrificial pattern 652 may be removed through the lower gate contact opening 250 to form a lower gate electrode opening 1410 in the first insulating layer 226 (Block 305 in FIG. 3).

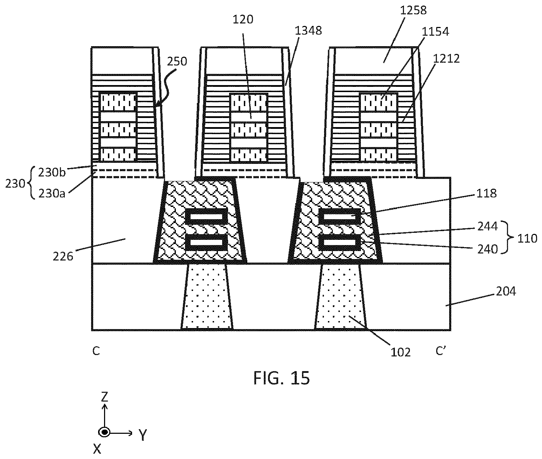

Referring to FIGS. 3 and 15, the lower gate electrode 110, including the lower work function layer 240 and the lower metal gate layer 244, may be formed in the lower gate electrode opening 1410 (referring to FIG. 14) (Block 307 in FIG. 3).

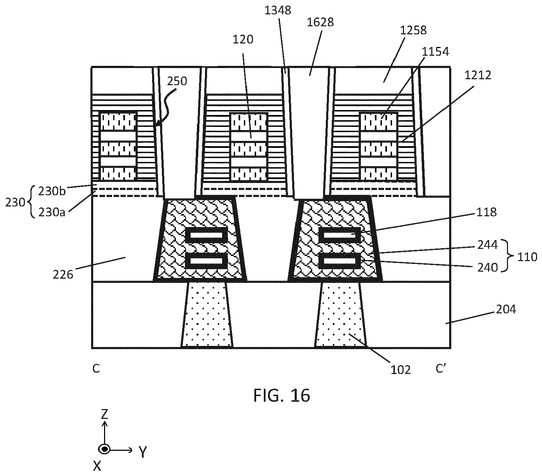

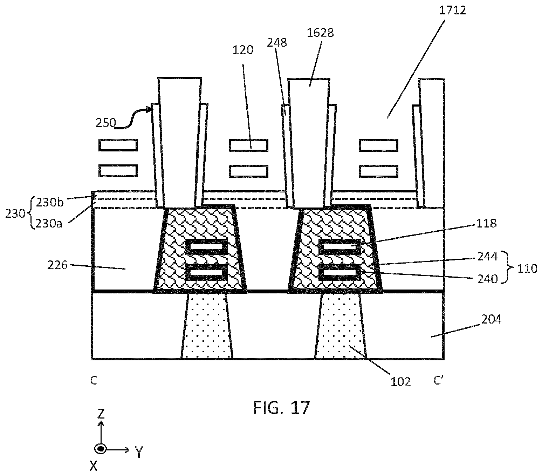

Referring to FIGS. 3 and 16, a sacrificial insulating layer 1628 may be formed on the intergate insulator 230 and in the lower gate contact opening 250 (Block 309 in FIG. 3). The sacrificial insulating layer 1628 may be disposed on the preliminary contact insulator 1348. The sacrificial insulating layer 1628 may be formed in (e.g., fill) a remaining portion of the lower gate contact opening 250 after the formation of the preliminary contact insulator 1348. Referring to FIG. 17, the preliminary upper gate electrode 1212 and the upper sacrificial pattern 1154 may be removed to form an upper gate electrode opening 1712. A portion (e.g., an upper portion) of the preliminary contact insulator 1348 may be removed to form the contact insulator 248.

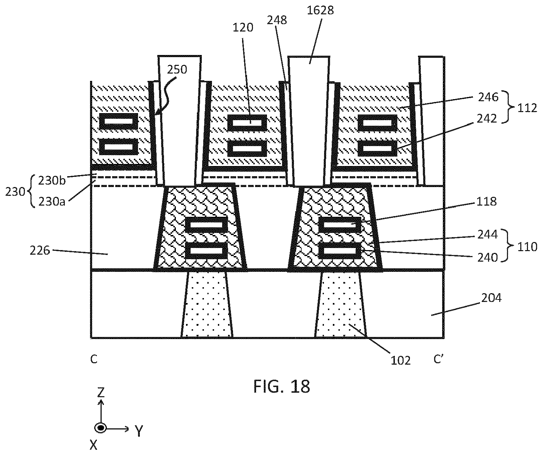

Referring to FIGS. 3 and 18, the upper gate electrode 112, including the upper work function layer 242 and the upper metal gate layer 246, may be formed in the upper gate electrode opening 1712 (referring to FIG. 17) (Block 311 in FIG. 3).

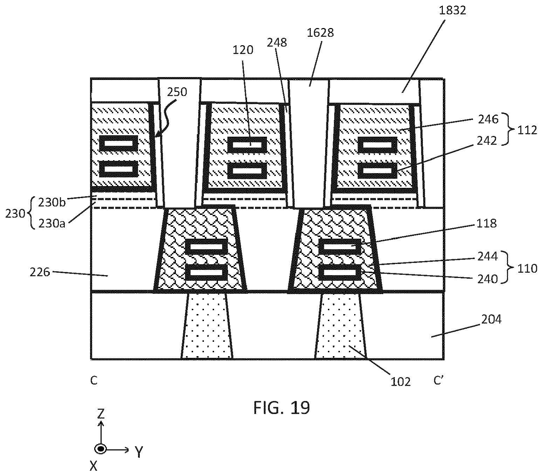

Referring to FIG. 19, a preliminary third insulating layer 1832 may be formed on the upper gate electrode 112, the sacrificial insulating layer 1628, and the contact insulator 248. For example, the preliminary third insulating layer 1832 may be formed on upper surfaces of the upper gate electrode 112 and the contact insulator 248. An upper surface of the preliminary third insulating layer 1832 may be coplanar with an upper surface of the sacrificial insulating layer 1628.

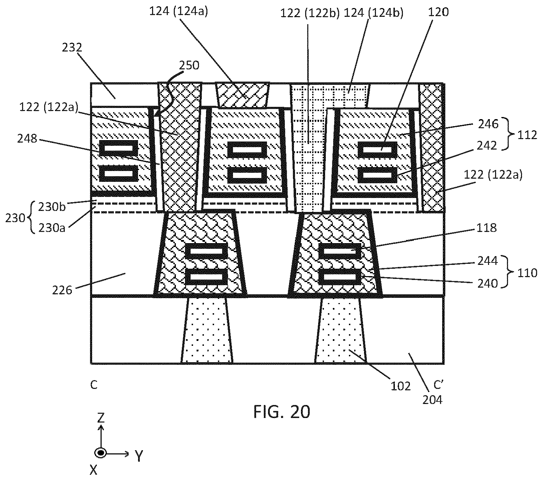

Referring to FIG. 20, the sacrificial insulating layer 1628 in the lower gate contact opening 250 may be removed, and a portion of the preliminary third insulating layer 1832 may be removed to form the third insulating layer 232. The lower gate contact 122 may be formed in the lower gate contact opening 250 (between the contact insulators 248). For example, the sacrificial insulating layer 1628 may be at least partially replaced with the lower gate contact 122. In some embodiments, the lower gate contact 122 may be in (e.g., may extend through) the third insulating layer 232. The remaining portion of the sacrificial insulating layer 1628 disposed other than the inside of the lower gate contact opening 250 may be the second insulating layer 228 (referring to FIGS. 2A and 2B). In the subsequent processes, upper gate contact 124 may be formed in the third insulating layer 232, and the fourth insulating layer 234 may be formed on the third insulating layer 232, the lower gate contact 122, and/or the upper gate contact 124 (referring back to FIG. 2C).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, "adjacent to", or "on," another element, it can be directly coupled, connected, or responsive to, adjacent to, or on, the other element, or intervening elements may also be present. In contrast, when an element is referred to as being "directly coupled," "directly connected," or "directly responsive" to, "directly adjacent to", or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

In one example, when a certain embodiment may be implemented differently, processes or methods may occur in a sequence different from that specified in the description herein. For example, two consecutive processes may actually be executed at the same time. Depending on a related function or operation, the processes may be executed in a reverse sequence. Moreover, a process may be separated into multiple processes and/or may be at least partially integrated.

In descriptions of temporal relationships, for example, temporal precedent relationships between two events such as "after", "subsequent to", "before", etc., another event may occur therebetween unless "directly after", "directly subsequent" or "directly before" is not indicated.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and modifications, enhancements, and other embodiments, which fall within the scope of the appended claims, are possible.

## Claims

1. An integrated circuit device comprising:
an upper transistor structure on a substrate, the upper transistor structure comprising a pair of upper source/drain regions spaced apart from each other in a first horizontal direction and an upper gate electrode between the pair of upper source/drain regions;
a lower transistor structure between the substrate and the upper transistor structure, the lower transistor structure comprising a lower gate electrode;
an upper insulating layer on the lower transistor structure, wherein the upper gate electrode is in the upper insulating layer; and
a lower gate contact extending through the upper insulating layer and contacting the lower gate electrode,
wherein a center of the upper gate electrode in a second horizontal direction and a center of the lower gate electrode in the second horizontal direction are offset from each other in the second horizontal direction, and
the second horizontal direction is perpendicular to the first horizontal direction.

2. The integrated circuit device of Claim 1, wherein the lower gate electrode comprises a first portion that is not overlapped by the upper gate electrode and a second portion that is overlapped by the upper gate electrode.

3. The integrated circuit device of Claim 2. wherein the upper gate electrode comprises a first portion that is not overlapped by the lower gate electrode and a second portion that is overlapped by the lower gate electrode.

4. The integrated circuit device of Claim 2 or 3, wherein the lower gate contact is in contact with the first portion of the lower gate electrode.

5. The integrated circuit device of any one of Claims 1 to 4, further comprising an intergate insulator extending between the lower gate electrode and the upper gate electrode,
wherein the lower gate electrode comprises a lower metal gate layer and a lower work function layer, and the lower work function layer extends between the intergate insulator and the lower metal gate layer.

6. The integrated circuit device of any one of Claims 1 to 5, wherein the upper transistor structure is a first upper transistor, and the upper gate electrode is a first upper gate electrode,
the integrated circuit device further comprises a second upper transistor comprising a second upper gate electrode that is spaced apart from the first upper gate electrode in the second horizontal direction,
wherein the lower gate contact extends between the first upper gate electrode and the second upper gate electrode.

7. The integrated circuit device of Claim 6, further comprising an intergate insulator extending between the lower gate electrode and the first and second upper gate electrodes,
wherein the lower gate contact extends through the intergate insulator.

8. The integrated circuit device of any one of Claims 1 to 7, wherein the upper transistor structure further comprises an upper channel region, and the lower transistor structure further comprises a lower channel region, and
a center of the upper channel region in the second horizontal direction and a center of the lower channel region in the second horizontal direction are offset from each other in the second horizontal direction.

9. An integrated circuit device comprising:
first and second upper transistor structures that are on a substrate and are spaced apart from each other in a horizontal direction, the first and second upper transistor structures comprising first and second upper gate electrodes, respectively;
a lower transistor structure between the substrate and the first and second upper transistor structures, the lower transistor structure comprising a lower gate electrode that comprises a portion not overlapped by the first and second upper gate electrodes;
an intergate insulator extending between the lower gate electrode and the first and second upper gate electrodes; and
a lower gate contact between the first and second upper gate electrodes, the lower gate contact extending through the intergate insulator and is contact with the portion of the lower gate electrode.

10. The integrated circuit device of Claim 9, wherein the lower gate electrode comprises a lower metal gate layer and a lower work function layer, and the lower work function layer extends between the intergate insulator and the lower metal gate layer.

11. The integrated circuit device of Claim 10, wherein the lower work function layer contacts the intergate insulator.

12. The integrated circuit device of any one of Claims 9 to 11, wherein the first upper transistor structure further comprises a first upper channel region, and the lower transistor structure further comprises a lower channel region, and
a center of the first upper channel region in the horizontal direction and a center of the lower channel region in the horizontal direction are offset from each other in the horizontal direction.

13. The integrated circuit device of Claim 12, wherein a center of the first upper gate electrode in the horizontal direction and a center of the lower gate electrode in the horizonal direction are offset from each other in the horizontal direction.

14. A method of forming an integrated circuit device, the method comprising:
forming a preliminary structure on a substrate, the preliminary structure comprising a preliminary upper structure and a preliminary lower structure between the substrate and the preliminary upper structure, the preliminary lower structure comprising a lower insulator and a preliminary lower gate electrode in the lower insulator, and the preliminary upper structure comprising a preliminary upper gate layer;
forming a lower gate contact opening extending through the preliminary upper gate layer, thereby forming first and second preliminary upper gate electrodes, the lower gate contact opening exposing the preliminary lower gate electrode, and the first and second preliminary upper gate electrodes being spaced apart from each other in a horizontal direction;
removing the preliminary lower gate electrode through the lower gate contact opening, thereby forming a lower gate electrode opening in the lower insulator;
forming a lower gate electrode in the lower gate electrode opening; and
forming a lower gate contact in the lower gate contact opening.

15. The method of Claim 14, wherein the lower gate electrode comprises a portion that is not overlapped by the first and second preliminary upper gate electrodes, and
the lower gate contact is in contact with the portion of the lower gate electrode.
